# EUROPÄISCHE PATENTSCHRIFT

(11) **EP 0 405 165 B1**
(45) Veröffentlichungstag und Bekanntmachung des Hinweises auf die Patenterteilung: **18.09.1996**
(21) Anmeldenummer: 90110277.2
(22) Anmeldetag: 30.05.1990
(51) Int. Cl.: H05K 5/00, H05K 5/06

(54) **Mobiles Steuergehäuse**
Movable control case
Boîtier de contrôle mobile

(30) Priorität: 27.06.1989 DE 3920963
(43) Veröffentlichungstag der Anmeldung: 02.01.1991
(73) Patentinhaber: Rose-Elektrotechnik GmbH + Co KG Elektrotechnische Fabrik, D-32457 Porta Westfalica (DE)
(72) Erfinder: Pohlmann, Franz, D-4950 Minden (DE); Porde, Christoph, D-4512 Wallenhorst/Rulle 2 (DE)
(74) Vertreter: Hanewinkel, Lorenz, Dipl.-Phys.

(56) Entgegenhaltungen:
- EP-A- 0 037 574
- EP-A- 0 078 405
- DE-A- 2 808 997
- DE-U- 8 533 097
- DE-U- 8 905 589

## Beschreibung

Die Erfindung bezieht sich auf ein mobiles Steuergehäuse mit elektronischen Steuerungseinbauten und mit zwei inneren, zwischen sich die Steuerungseinbauten aufnehmenden Seitenprofilen, zwei an den beiden Längenenden der inneren Seitenprofile unter Steckverbindung angesetzten inneren Kappen, sowie einer Frontplatte und einer Rückwand, die auf den inneren Seitenprofilen und den inneren Kappen aufliegen und daran durch Schrauben befestigt sind.

Die bisher auf dem Markt befindlichen mobilen Steuergehäuse sind als Eintastergehäuse oder Mehrtastergehäuse ausgeführt bzw. sind mit Folientastatur ausgerüstet und haben dabei immer bestimmte Größen, die jedoch den heutigen Ansprüchen nicht mehr gerecht werden.

So offenbart das DE-A-2808 997 einen quaderförmigen Kasten zur Aufnahme elektrischer oder elektronischer Schaltungen, bestehend aus Deckteil und Bodenteil, welche beidseitig mit paarweise fluchtenden Seitenteilen in Nuten je mindestens einer dazwischen gefügten Profilschiene gesteckt sind, wobei die freien Stirnenden der Profilschienen innerhalb von Deck- und Bodenteil liegen und Anschläge bilden für beidseitig zwischen Deckteil und Bodenteil gefügte Stirnwände.

Aufgrund von Marktbeobachtungen hat es sich gezeigt, daß der Umfang an Einbauten von komplexen Elektroniksteuerungen und insbesondere der Einbau von Folientastaturen und Anzeigen (Displays) zunehmend an Bedeutung für Steuerungsabläufe bei hochwertigen Maschinen und Anlagen gewinnt und hierfür größere und flachere Gehäuse gewünscht werden.

Das in der DE-A- 28 08 977 offenbarte Gehäuse wird jedoch bei einem flachen Aufbau und großer Front- und Rückplatte zur Aufnahme der Bedienungselemente recht instabil.

Außerdem ist der Ein- und Ausbau der mechanischen und/oder elektronischen Steuerungseinbauten umständlich.

Aufgabe der Erfindung ist es daher, ein mobiles Steuergehäuse aus wenigen unterschiedlichen Einzelteilen zu schaffen, das aufgrund der besonderen Gestaltung seiner Einzelteile in verschiedenen flachen Größen ausführbar ist und einen einfachen Ein- und Ausbau der Steuerungseinbauten zuläßt sowie die Einbauten sicher abgekapselt aufnimmt.

Diese Aufgabe wird erfindungsgemäß durch die kennzeichnenden Merkmale des Patentanspruches 1 gelöst, wobei noch die in den Unteransprüchen aufgeführten Gestaltungsmerkmale vorteilhafte Weiterbildungen der Aufgabenlösung darstellen.

Das erfindungsgemäße mobile Steuergehäuse besitzt innere und äußere Seitenprofile, die als Strangpreßprofile ausgelegt sind, wodurch in vorteilhafter Weise das Gehäuse in jeder gewünschten Länge hergestellt werden kann, wobei die flache Bauweise beibehalten wird.

Das innere und äußere Seitenprofil läßt sich sowohl links als auch rechts einsetzen, so daß für beide Seitenprofile jeweils nur ein Profiltyp erforderlich ist.

Ebenfalls wird für die beiden inneren Kappen nur ein Kappentyp erforderlich und die ausbrechbare Kabeldurchführung ist außer Mitte angeordnet, so daß durch Wenden der Kappe die Zuführung sowohl an der linken als auch an der rechten Seite des Steuergehäuses erfolgen kann.

Weiterhin ist für die beiden äußeren Kappen ebenfalls nur ein Kappentyp vorhanden und in dieser äußeren kann dann entsprechend der inneren Kappe für die Kabeldurchführung ein ausbrechbares Wandungsteil angedeutet sein.

In dem Stoß zwischen den inneren Seitenprofilen und der inneren Kappe ist jeweils eine gestanzte Gummidichtung angeordnet und zwischen den inneren Seitenprofilen und den inneren Kappen verläuft unter der Frontplatte bzw. der Rückwand eine umlaufende Dichtung, so daß die Steuerungseinbauten in dem Steuergehäuse abgekapselt untergebracht ist.

Der Ein- und Ausbau von vorkonfektionierten Steuerungen ist in einfacher und bequemer Weise durch die Kappen möglich, indem eine äußere und eine innere Kappe gelöst wird und dann ein Zugang zum Gehäuseinnenraum geschaffen worden ist.

Dieses mobile Steuergehäuse ist sowohl für mechanische Einbauten, z.B. Taster (Kransteuergehäuse) als auch für elektronische Einbauten, z.B. Folientastaturen und Anzeigen (Programmiergehäuse) ausgelegt.

Dieses Steuergehäuse zeigt eine handliche Gestaltung und kann aufgrund seinen geringen Gewichtes mit einer Hand gehalten werden, so daß die andere Hand zur Bedienung frei ist.

Weiterhin ist für die beiden äußeren Kappen ebenfalls nur ein Kappentyp vorhanden und in dieser äußeren Kappe kann dann entsprechend der inneren Kappe für die Kabeldurchführung ein ausbrechbares Wandungsteil angedeutet sein.

In dem Stoß zwischen den inneren Seitenprofilen und der inneren Kappe ist jeweils eine gestanzte Gummidichtung angeordnet und zwischen den inneren Seitenprofilen und den inneren Kappen verläuft unter der Frontplatte bzw. der Rückwand eine umlaufende Dichtung, so daß die Steuerungseinbauten in dem Steuergehäuse abgekapselt untergebracht sind.

Der Ein- und Ausbau von vorkonfektionierten Steuerungen ist in einfacher und bequemer Weise durch die Kappen möglich, indem eine äußere und eine innere Kappe gelöst wird und dann ein Zugang zum Gehäuseinnenraum geschaffen worden ist.

Dieses mobile Steuergehäuse ist sowohl für mechanische Einbauten, z. B. Taster (Kransteuergehäuse) als auch für elektronische Einbauten, z. B. Folientastaturen und Anzeigen (Programmiergehäuse) ausgelegt.

Dieses Steuergehäuse zeigt eine handliche Gestaltung und kann aufgrund seines geringen Gewichtes mit einer Hand gehalten werden, so daß die andere Hand zur Bedienung frei ist.

Auf den Zeichnungen ist ein Ausführungsbeispiel der Erfindung dargestellt, welches nachfolgend näher erläutert wird. Es zeigt:
- Fig. 1: einen Längsschnitt durch ein mobiles Steuergehäuse, bestehend aus zwei inneren Seitenprofilen, zwei inneren Kappen, zwei äußeren Kappen, einer Frontplatte und einer Rückwand und zwei äußeren Seitenprofilen, gemäß Schnittlinie I-I in Fig. 2,
- Fig. 2: eine Draufsicht im teilweisen Schnitt auf dasselbe Steuergehäuse,
- Fig. 3: einen Querschnitt durch das Steuergehäuse, wobei die beiden inneren Seitenprofile, die beiden äußeren Seitenprofile und die Frontplatte und Rückwand gezeigt sind, gemäß Schnittlinie II-II in Fig. 2,
- Fig. 4: einen Querschnitt durch dasselbe Steuergehäuse gemäß Schnittlinie III-III in Fig. 2, bei dem die innere Kappe, die Frontplatte und die Rückwand und die äußere Kappe gezeigt sind,
- Fig. 5 bis 7: eine Außenansicht, eine Draufsicht und eine Innenansicht der äußeren Kappe,
- Fig. 8: einen Querschnitt durch die äußere Kappe,
- Fig. 9: einen Querschnitt durch das innere Seitenprofil,
- Fig. 10 bis 12: eine Draufsicht, eine Innenansicht und eine Außenansicht der inneren Kappe,
- Fig. 13: einen Querschnitt durch die innere Kappe,
- Fig. 14: einen Querschnitt durch das äußere Seitenprofil,
- Fig. 15: eine Vorderansicht einer Dichtung.

Das mobile Steuergehäuse besteht aus zwei inneren Seitenprofilen (1), zwei äußeren Seitenprofilen (2), zwei inneren Kappen (3), zwei äußeren Kappen (4), einer Frontplatte und einer Rückwand (5) und vier Dichtungen (6).

Die beiden inneren Seitenprofile (1) nehmen zwischen sich elektronische Steuerungsteile (nicht dargestellt) auf und an die beiden Längenenden dieser inneren Seitenprofile (1) legt sich jeweils die innere Kappe (3) unter Steckverbindung an.

Auf den beiden inneren Seitenprofilen (1) ist eine Frontplatte und eine Rückwand (5) durch Schrauben befestigt. Die beiden inneren Kappen (3) und die Längenenden der Frontplatte (5) und der Rückwand (5) werden von den beiden äußeren Kappen (4) überfaßt.

Zwischen den beiden äußeren Kappen (4) erstreckt sich über die gesamte Länge des Steuergehäuses an beiden Längsseiten jeweils ein äußeres Seitenprofil (2), welches jeweils ein inneres Seitenprofil (1) sowie die Längenrandbereiche der Frontplatte (5) und Rückwand (5) überfaßt.

Zwischen den Stirnenden der inneren Seitenprofile (1) und den inneren Kappen (3) ist jeweils die Dichtung (6) angeordnet und zwischen Frontplatte bzw. Rückwand (5) und den inneren Seitenprofilen (1) und den inneren Kappen (3) erstreckt sich je eine umlaufende Dichtung (7).

Die inneren und äußeren Seitenprofile (1, 2) sind jeweils von Kunststoffstrangpreßprofilen gebildet.

Die beiden inneren und die beiden äußeren Seitenprofile (1, 2) sind im Querschnitt identisch ausgebildet und lediglich spiegelbildlich angeordnet.

Weiterhin sind die beiden inneren Kappen (3) und die beiden äußeren Kappen (4) sowie die Dichtungen (6) jeweils gleichartig aufgebaut, was auch für die Frontplatte und die Rückwand (5) gilt, so daß für die insgesamt vierzehn Einzelteile des Steuergehäuses nur sechs Einzelteiltypen erforderlich sind.

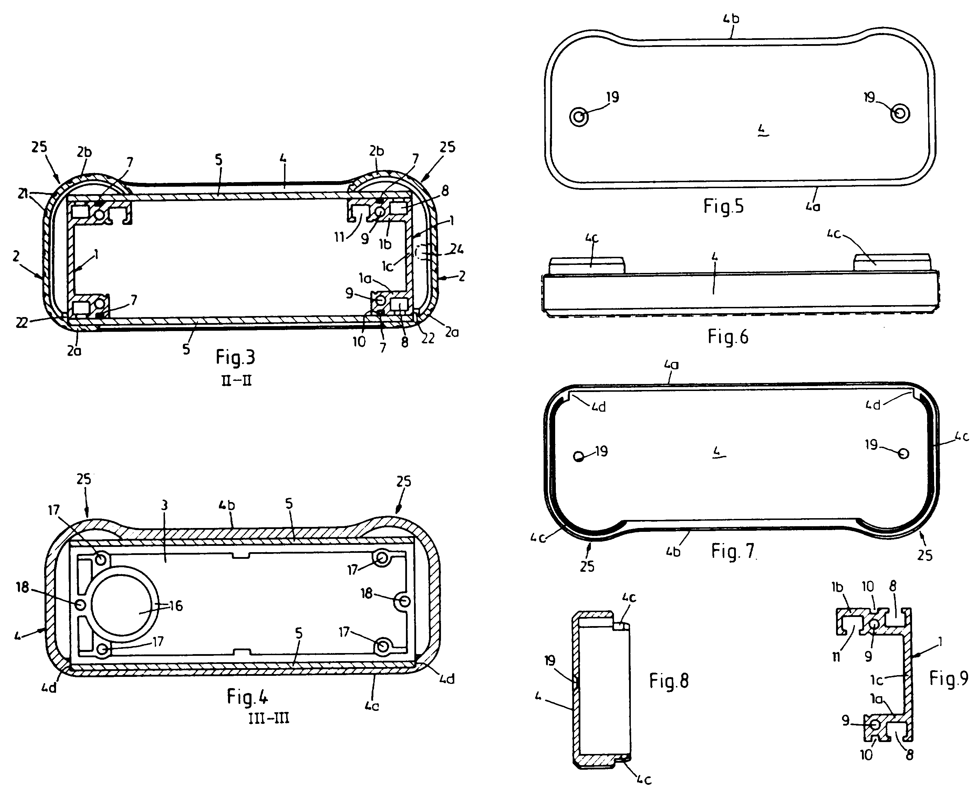

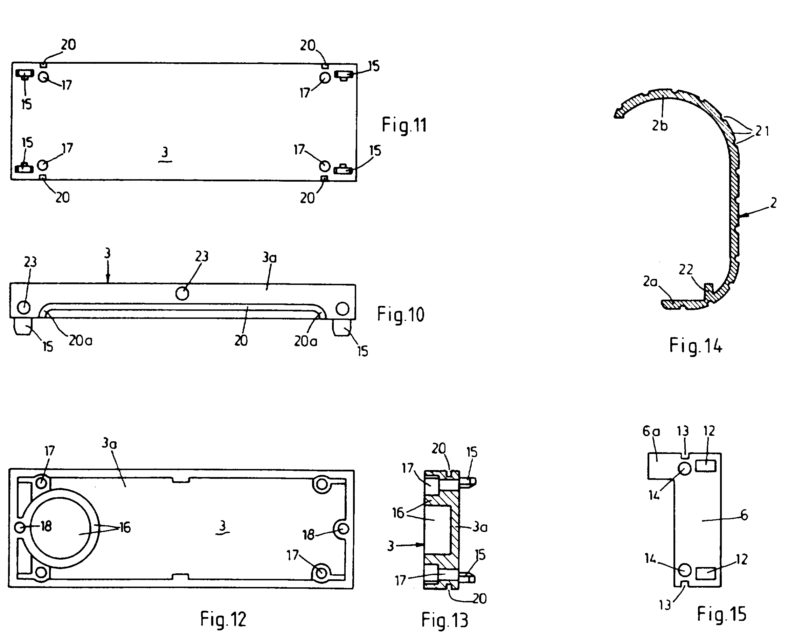

Das innere Seitenprofil (1) zeigt einen U-förmigen Querschnitt mit zwei unterschiedlich langen U-Schenkeln (1a, 1b) (vgl. Fig. 3 und 9).

In den beiden U-Schenkein (1a, 1b) ist außenseitig im Anschluß an den U-Steg (1c) jeweils ein durchgehender, im Querschnitt hinterschnittener Kanal (8) mit vorzugsweise eckigem, wie rechteckigem oder quadratischem Querschnitt ausgeformt, der sich über die gesamte Länge des inneren Seitenprofiles (1) erstreckt und für die Steckverbindung mit der inneren Kappe (3) dient.

Weiterhin ist in jedem U-Schenkel (1a, 1b) ein Schraubkanal (9) für die Befestigungsschrauben der inneren Kappe (3) vorgesehen und an der Außenseite jedes U-Schenkels (1a, 1b) liegt im Abstand neben dem Kanal (8) jeweils eine über die gesamte Profillänge verlaufende Nut (10) für die Dichtung (7).

Außerdem zeigt der längere U-Schenkel (1b) einen innenseitig offenen, im Querschnitt hinterschnittenen Kanal (11) zur Befestigung der elektronischen Steuerteile, die auch zwischen den beiden U-Schenkeln (1a, 1b) eingesetzt werden können.

Die Dichtung (6) ist von einer gestanzten Gummidichtung gebildet und entspricht im Querschnitt etwa dem Querschnitt des inneren Seitenprofiles (1), indem sie als Rechteckplatte mit einem Ansatz (6a) versehen ist, der dem längeren U-Schenkel (1b) angepaßt ist (vgl. Fig. 15).

In dieser plattenförmigen Dichtung (6) sind entsprechend den Kanälen (8) zwei Durchbrüche (12) und zwei Nuten (13) für die Dichtung (7) sowie zwei Durchstecklöcher (14) für die Befestigungsschrauben der inneren Kappe (3) ausgestanzt.

Die innere Kappe (3), gemäß Fig. 4 bis 13, zeigt eine rechteckige Grundform mit ebener, an den Stirnenden der inneren Seitenprofile (1) anliegender Kappenwandung (3a), die die innere Seite der Kappe (3) darstellt.

An dieser ebenen Kappenwandung (3a) sind in den Eckbereichen vier Steckzapfen (15) angeformt, mit denen jede innere Kappe (3) durch die Durchbrüche (12) der Dichtungen (6) hindurch und in die Kanäle (8) des inneren Seitenprofiles (1) eingesteckt wird.

Von der ebenen Kappenwandung (3a) aus ist die Kappe (3) nach außen hin kastenartig ausgebildet und zeigt in einem Endbereich eine ausbrechbare Kabeldurchführung (16).

Die Kappe (3) besitzt mehrere, vorzugsweise vier, Durchstecklöcher (17) zur Befestigung an den beiden inneren Seitenprofilen (1), indem durch diese Löcher (17) und die Löcher (14) in den Dichtungen (6) die Befestigungsschrauben hindurchgesteckt und in die Schraubkanäle (9) eingeschraubt werden.

In den beiden Längenendbereichen der inneren Kappe (3) ist auf der Breitenhalbierenden jeweils ein weiteres Durchsteckloch (18) für eine Befestigungsschraube zum Befestigen der äußeren Kappen (4) ausgenommen.

In der inneren Kappe (3) ist an beiden Längsseiten eine Nut (20) ausgespart, die einen größten Teil der Kappenlänge einnimmt und im Abstand vor den Steckzapfen (15) in einem Bogen (20a) ausläuft, wobei dieser Bogen (20a) mit den Nuten (10, 13) der inneren Seitenprofile (1) und der Dichtungen (6) zusammentrifft, so daß über die gesamte Länge der inneren Seitenprofile (1) und dann quer zu den Seitenprofilen (1) über die inneren Kappen (3) ein umlaufender, in der Draufsicht rechteckiger und durch die Bogen (20a) eckseitig abgerundeter Einlegekanal für die umlaufende Dichtung (7) zwischen Frontplatte (5) bzw. Rückwand (5) und inneren Seitenprofilen (1) und inneren Kappen (3) geschaffen worden ist.

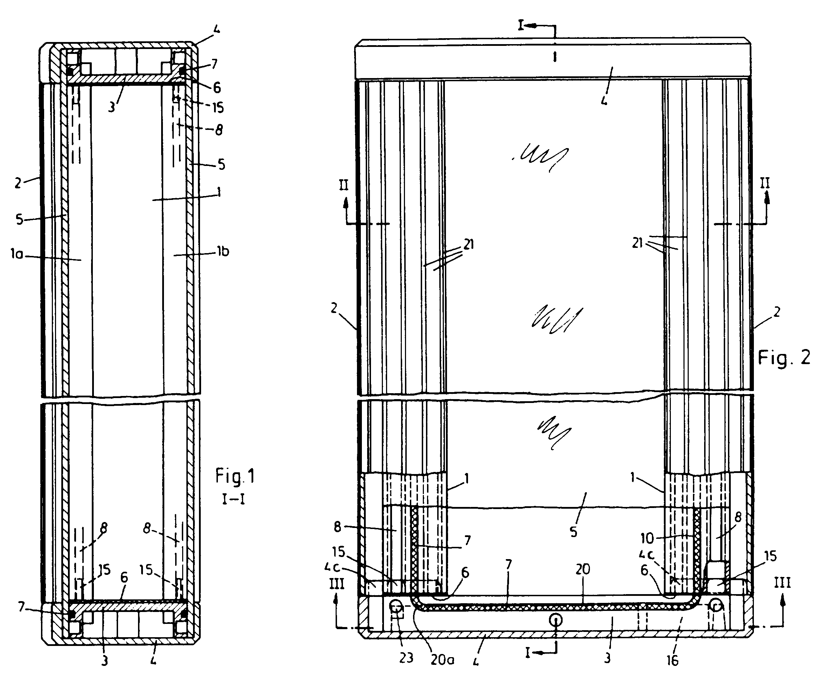

Die äußere Kappe (4) gemäß Fig. 2, 5 bis 8, zeigt an einer Längsseite eine gerade Längskante (4a) und an der gegenüberliegenden Längsseite eine muldenartig eingezogene Längskante (4b) und hat zwei seitliche, C-bogenförmige, in die äußeren Seitenprofile (2) eingreifende Kragen (4c). Dabei enden diese Kragen (4c) an der geraden Längskante (4a) in einer innenseitigen Abstufung (4d), mit der die äußere Kappe (4) eine Längskante der inneren Kappe (3) und die Stirnkante der Frontplatte bzw. Rückwand (5) überfaßt.

Die muldenartig eingezogene Längskante (4b) bildet mit ihren C-Bogen und den C-Bogen (2a, 2b) der äußeren Seitenprofile (2) einen umlaufenden Schutzkragen (25) für die vertieft liegende Frontplatte (5) oder vertieft liegende Rückwand (5).

In der äußeren Kappe (4) sind entsprechend den Löchern (18) der inneren Kappe (3) zwei Durchstecklöcher (19) für die Befestigungsschrauben zur Festlegung der äußeren Kappe (4) an der inneren Kappe (3) vorgesehen.

Das äußere Seitenprofil (2) gemäß Fig. 3 und 14 zeigt einen C-förmigen Querschnitt mit außenseitig profilierter Grifffläche (21) und hat innenseitig an einem C-Bogen (2a) einen Anschlagsteg (22), mit dem sich das äußere Seitenprofil (2) an den Steg (1c) der inneren Seitenprofile (1) anlegt.
Die beiden C-Bogen (2a, 2b) des äußeren Seitenprofiles (2) sind unterschiedlich in der Bogenlänge, wobei dieser C-Querschnitt auch in den beiden Seitenbereichen der äußeren Kappe (4) vorhanden ist, so daß das äußere Seitenprofil (2) mit der äußeren Kappe (4) im Stoßbereich bündig abschließt.

Die Frontplatte (5) und die Rückwand (5) sind von rechteckigen Platten gebildet, deren Breite der Länge der inneren Kappe (3) entspricht und die sich über die gesamte Steuergerätelänge zwischen den beiden äußeren Kappen (4) erstrecken.

Die Frontplatte (5) und Rückwand (5) werden durch Schrauben auf den beiden inneren Kappen (3) befestigt, indem sie in Schraublöcher (23) der inneren Kappen (3) eingreifen.

Dieses mobile Steuergehäuse läßt sich sowohl mit Drucktaster als auch mit Folientastatur ausrüsten.

Die beiden äußeren Seitenprofile (2) werden durch Klemmverbindung auf der Frontplatte und Rückwand (5) sowie zwischen den angeschraubten äußeren Kappen (4) festgelegt.

Alternativ besteht die Möglichkeit, an den äußeren Seitenprofilen (2) innenseitig Schraubaufnahmen (24) anzuformen, mit denen sie mit entsprechenden, an der inneren Kappe (3) angeformten Gegenstücken durch Schrauben zusätzlich befestigt werden können, vgl. strichpunktierte Darstellung in Fig. 3

Die Frontplatte (5) als Bedienungsseite wird beim Einsatz von Drucktaster durch den umlaufenden Schutzkragen (25) geschützt, so daß sie vertieft im Gehäuse liegt.

Wird eine Folientastatur eingesetzt, dann kann die Frontplatte (5) gewechselt werden und liegt dann an der ebenen Gehäuseseite dem Schutzkragen (25) gegenüber, wodurch ein leichtes Bedienen möglich ist, da die Bedienungsperson den Schutzkragen (25) nicht übergreifen muß - dieser liegt an der Gehäuse-Rückseite und überfaßt die Rückwand (5).

## Patentansprüche

1. Mobiles Steuergehäuse mit elektronischen Steuerungseinbauten, und mit inneren, zwischen sich die Steuerungseinbauten aufnehmenden Seitenprofilen,
zwei an den Längenenden der inneren Seitenprofile unter Steckverbindung angesetzten inneren Kappen,
sowie einer Frontplatte und einer Rückwand, die auf den inneren Seitenprofilen und den inneren Kappen aufliegen und daran durch Schrauben befestigt sind,
dadurch gekennzeichnet, daß
das Gehäuse zusätzliche zwei äußere, die inneren Kappen (3) und die Längenenden der Frontplatte (5) und Rückwand (5) übergreifenden Kappen (4)
und zwei äußere, zwischen den äußeren Kappen (4) liegende und die inneren Seitenprofile (1) sowie die Längenrandbereiche der Frontplatte (5) und Rückwand (5) überfassende Seitenprofile (2) aufweist,
und die beiden inneren und die beiden äußeren Seitenprofile (1, 2) jeweils im Querschnitt identisch und spiegelbildlich angeordnet und die beiden inneren Kappen (3) und die beiden äußeren Kappen (4) jeweils gleich Grundform haben und spiegelbildlich angeordnet sind.

2. Steuergehäuse nach Anspruch 1, dadurch gekennzeichnet, daß zwischen den Stirnenden der inneren Seitenprofile (1) und den inneren Kappen (3) je eine Dichtung (6) angeordnet und zwischen Frontplatte (5) bzw. Rückwand (5) und den inneren Seitenprofilen (1) und den inneren Kappen (3) je eine umlaufende Dichtung (7) liegt.

3. Steuergehäuse nach einem der Ansprüche 1 und 2, dadurch gekennzeichnet, daß die inneren und äußeren Seitenprofile (1, 2) von Kunststoffstrangpreßprofilen gebildet sind.

4. Steuergehäuse nach einem der Ansprüche 1 bis 3, dadurch gekennzeichnet, daß das innere Seitenprofil (1) einen U-förmigen Querschnitt mit zwei unterschiedlich langen U-Schenkeln (1a, 1b) besitzt, in beiden U-Schenkeln (1a, 1b) jeweils ein durchgehender Kanal (8) für die Steckverbindung mit der inneren Kappe (3) und je ein Schraubkanal (9) für die Schraubverbindung mit der Kappe (3) sowie außenseitig eine durchgehende Nut (10) für die Dichtung (7) ausgeformt sind und am längeren U-Schenkel (1b) ein nach innen offener, durchgehender Kanal (11) zur Befestigung von Steuerungseinbauten vorgesehen ist.

5. Steuergehäuse nach einem der Ansprüche 1 bis 4, dadurch gekennzeichnet, daß die innere Kappe (3) eine rechteckige Grundform mit ebener, an den Stirnenden der inneren Seitenprofile (1) anliegender Kappenwandung (3a) besitzt, an der vier Steckzapfen (15) angeformt sind, die in die Kanäle (8) der inneren Seitenprofile (1) eingreifen.

6. Steuergehäuse nach einem der Ansprüche 1 bis 5, dadurch gekennzeichnet, daß die innere Kappe (3) zur äußeren Kappe (4) hin kastenartig ausgebildet ist und in einem Endbereich eine ausbrechbare Kabeldurchführung (16) aufweist sowie mehrere Durchsteck- und Schraublöcher (17, 18) für die Befestigung der Kappe (3) mittels Schrauben in den Schraubkanälen (9) der inneren Seitenprofile (1) und für die Befestigung der äußeren Kappe (4) mittels Schrauben an der inneren Kappe (3) aufweist.

7. Steuergehäuse nach einem der Ansprüche 1 bis 6, dadurch gekennzeichnet, daß in der inneren Kappe (3) an beiden Längsseiten eine Nut (20) ausgespart ist, die im Abstand vor den Steckzapfen (15) in einen Nutbogen (20a) ausläuft, der mit den Nuten (10) der inneren Seitenprofile (1) fluchtet, wobei diese Nut (20) in den beiden inneren Kappen (3) mit der Nut (10) in den beiden inneren Seitenprofilen (1) jeweils einen umlaufenden, der Frontplatte (5) und auch der Rückwand (5) benachbarten Einlegekanal für die Ringdichtung (7) bildet.

8. Steuergehäuse nach einem der Ansprüche 1 bis 7, dadurch gekennzeichnet, daß die äußere Kappe (4) an einer Längsseite eine gerade Längskante (4a) und und an der gegenüberliegenden Längsseite eine muldenartig eingezogene Längskante (4b) und zwei seitliche, C-bogenförmige, in die äußeren Seitenprofile (2) eingreifende Kragen (4c) besitzt.

9. Steuergehäuse nach einem der Ansprüche 1 bis 8, dadurch gekennzeichnet, daß die Kragen (4C) an der geraden Längskante (4a) der äußeren Kappe (4) in einer innenseitigen, die Frontplatte bzw. Rückwand (5) und die innere Kappe (3) fixiert übergreifenden Abstufung (4d) enden und in der Kappe (4) Durchstecklöcher (19) für in die Schraublöcher (18) der inneren Kappe (3) eingreifende Befestigungsschrauben besitzt.

10. Steuergehäuse nach einem der Ansprüche 1 bis 9, dadurch gekennzeichnet, daß das äußere Seitenprofil (2) einen C-förmigen Querschnitt mit außenseitig profilierter Grifffläche (21) und zwei unterschiedlich langen C-Bogen (2a, 2b) hat, wobei an dem einen C-Bogen (2a) ein Anlagesteg (22) angeformt ist, mit dem sich das äußere Seitenprofil (2) an den Steg (lc) der inneren Seitenprofile (1) anlegt.

11. Steuergehäuse nach einem der Ansprüche 1 bis 10, dadurch gekennzeichnet, daß die äußere Kappe (4) entsprechend dem C-Querschnitt der äußeren Seitenprofile (2) im Kragenverlauf ausgeführt ist und im Stoß mit den äußeren Seitenprofilen (2) bündig abschließt.

12. Steuergehäuse nach einem der Ansprüche 1 bis 11, dadurch gekennzeichnet, daß die Dichtung (6) von einer gestanzten Gummidichtung in rechteckiger Plattenform mit einem den längeren U-Schenkel (1b) des inneren Seitenprofiles (1) entsprechenden Ansatz (6a) und mit Durchbrüchen (12) für die Steckzapfen (15) mit Nuten (13) für die Dichtung (7) und mit Durchstecklöchern (14) für die Befestigungsschrauben der inneren Kappe (3) an den inneren Seitenprofilen (1) ausgestattet ist.

13. Steuergehäuse nach einem der Ansprüche 1 bis 12, dadurch gekennzeichnet, daß die Frontplatte (5) und die Rückwand (5) von rechteckigen Platten mit Durchstecklöchern zur Befestigung auf den inneren Kappen (3) und den inneren Seitenprofilen (1) mittels Schrauben gebildet ist.

## Claims

1. Mobile control cabinet containing built-in electronic control components and having inner side sections which between them accommodate the control components,
two inner covers set in a push-on fit on the two longitudinal ends of the inner side sections,
as well as a front panel and a rear panel which rest on the inner side sections and the inner covers and are fastened thereto by screws,
characterised in that
the cabinet additionally features two outer covers (4) which extend over the inner covers (3) and the longitudinal ends of the front panel (5) and rear panel (5)
and two outer side sections (2) situated between the outer covers (4) and which mask the inner side sections (1) and the longitudinal end regions of the front panel (5) and rear panel (5),
and the two inner and two outer side sections (1, 2) are in each case identical in cross-section and arranged in a mirrored image and the two inner covers (3) and the two outer covers (4) in each case have the same basic shape and are arranged in a mirrored image.

2. Control cabinet according to claim 1, characterised in that between the front ends of the inner side sections (1) and the inner covers (3) there is respectively arranged a seal (6) and between the front panel (5) or rear panel (5) and the inner side sections (1) and the inner covers (3) there is respectively situated an all-round seal (7).

3. Control cabinet according to either of claims 1 and 2, characterised in that the inner and outer side sections (1, 2) are constituted by extruded plastics profiles.

4. Control cabinet according to any of claims 1 to 3, characterised in that the inner side section (1) possesses a U-shaped cross-section with two U-legs (1a, 1b) of different lengths, in both legs of the U (1a, 1b) there are incorporated a respective continuous channel (8) for snap-on connection to the inner cover (3) and a respective threaded channel (9) for the screwed connection to the cover (3), as well as externally a continuous groove (10) for the seal (7), and on the longer leg of the U (1b) there is an inward-opening, continuous channel (11) for attaching built-in control components.

5. Control cabinet according to any of claims 1 to 4, characterised in that the inner cover (3) possesses a rectangular basic shape with a plane cover panel (3a) resting against the front ends of the inner side sections (1), on which cover panel (3a) are moulded four snap-in pins (15) which engage in the channels (8) in the inner side sections (1).

6. Control cabinet according to any of claims 1 to 5, characterised in that the inner cover (3) is shaped like a box towards the outer cover (4) and in one end portion features a knock-out cable passage (16) and a plurality of through-holes and screw-holes (17, 18) for attachment of the cover (3) by means of screws in the threaded channels (9) of the inner side sections (1) and for attaching the outer cover (4) by means of screws to the inner cover (3).

7. Control cabinet according to any of claims 1 to 6, characterised in that both long sides of the inner cover (3) have set in them a groove (20) which emerges some way before the snap-in pins (15) as a grooved curved (20a) which lines up with the grooves (10) in the inner side sections (1); this groove (20) in the two inner covers (3) forms with the groove (10) in the two inner side sections (1) a respective all-round insert channel, for the ring seal (7), adjacent to the front panel (5) and also to the rear panel (5).

8. Control cabinet according to any of claims 1 to 7, characterised in that the outer cover (4) possesses a straight longitudinal edge (4a) on one long side and on the opposing long side a troughed longitudinal edge (4b) and two lateral collars curved like a C (4c) which engage in the outer side sections (2).

9. Control cabinet according to any of claims 1 to 8, characterised in that on the straight longitudinal edge (4a) of the outer cover (4) the collars (4c) terminate in an internal step (4d) which extends in fixed manner over the front panel or rear panel (5) and the inner cover (3) and in the cover (4) incorporates through-holes (19) for fixing screws which engage in the screw-holes (18) in the inner cover (3).

10. Control cabinet according to any of claims 1 to 9, characterised in that the outer side section (2) has a C-shaped cross-section with externally ridged gripping surface (21) and two C-shaped curves (2a, 2b) of different lengths; moulded on one C-shaped curve (2a) is a contact web (22) which allows the outer side section (2) to bear against the web (1c) of the inner side sections (1).

11. Control cabinet according to any of claims 1 to 10, characterised in that the outer cover (4) is constructed as a collar to match the C-shaped cross-section of the outer side sections (2) and terminates flush at the joint with the other side sections (2).

12. Control cabinet according to any of claims 1 to 11, characterised in that the seal (6) is equipped with a punched rubber seal in rectangular plate form with a shoulder (6a) to match the longer U-leg (1b) of the inner side section (1) and with passages (12) for the snap-in pins (15) with grooves (13) for the seal (7) and with through-holes (14) for the fixing screws of the inner cover (3) on the inner side sections (1).

13. Control cabinet according to any of claims 1 to 12, characterised in that the front panel (5) and the rear panel (5) are constituted by rectangular plates with through-holes for attachment to the inner covers (3) and the inner side sections (1) by means of screws.

## Revendications

1. Boîtier de contrôle mobile boîtier présentant des inserts de contrôle électroniques, profilés latéraux, intérieurs, entre lesquels les inserts de commande sont montés,
deux capuchons intérieurs, raccordés par enfichage aux deux extrémités longitudinales des profilés latéraux, intérieurs,
ainsi qu'une plaque frontale et une paroi arrière, qui portent sur les profilés latéraux, intérieurs et les capuchons intérieurs et y sont fixés à l'aide de vis,
caractérisé en ce que
le boîtier présente en plus deux capuchons extérieurs (4) qui saisissent les capuchons intérieurs (3) et les extrémités longitudinales de la plaque frontale (5) et de la paroi arrière (5),
et deux profilés latéraux extérieurs (2) placés entre les capuchons extérieurs (4) et saississant, par dessus, les profilés latéraux intérieurs (1) ainsi que les bords longitudinaux de la plaque frontale (5) et de la paroi arrière (5),
et que les deux profilés latéraux intérieurs et les deux profilés latéraux extérieurs (1, 2) ont une section transversale identique et sont disposés inversés et que les deux capuchons intérieurs (3) et les deux capuchons extérieurs (4) ont la même forme de base et sont disposés inversés.

2. Boîtier de contrôle selon la revendication 1,
caractérisé en ce que
un joint d'étanchéité (6) est disposé entre les extrémités frontales des profilés latéraux intérieurs (1) et les capuchons intérieurs (3), tandis qu'un joint d'étanchéité continu (7) est inséré entre la plaque frontale (5) resp. la paroi arrière (5) et les profilés latéraux intérieurs (1) et les capuchons intérieurs (3).

3. Boîtier de contrôle selon la revendication 1 ou 2,
caractérisé en ce que
les profilés latéraux intérieurs et les profilés latéraux extérieurs (1, 2) consistent en des profilés extrudés en matière plastique.

4. Boîtier de contrôle selon l'une des revendications 1 à 3,
caractérisé en ce que
le profilé latéral intérieur (1) présente une section transversale en U dont les branches (1a, 1b) sont de différentes longueurs et que dans chacune de ces branches (1a, 1b) un canal continu (8), destiné au raccordement par enfichement du capuchon intérieur (3) et un canal à vis (9) destiné au raccordement par vissage du capuchon intérieur (3) sont formés, une rainure (10) destinée à recevoir le joint d'étanchéité continu (7) étant prévue du côté extérieur et la plus longue branche (1b) du U présentant un canal continu (11), ouvert vers l'intérieur et servant à la fixation des inserts de commande.

5. Boîtier de contrôle selon l'une des revendications 1 à 4,
caractérisé en ce que
le capuchon intérieur (3) a une forme de base rectangulaire avec une paroi (3a) plane portant contre les extrémités frontales des profilés latéraux intérieurs (1), cette paroi (3a) étant pourvue de quatre pièces d'emboîtement (15) formées, d'une pièce, à partir d'elle et s'engageant dans les canaux (8) des profilés latéraux intérieurs (1).

6. Boîtier de contrôle selon l'une des revendications 1 à 5,
caractérisé en ce que
le capuchon intérieur (3) est conçu sous forme de caisson en direction du capuchon extérieur (4) et présente, à l'une de ses extrémités, un passage de câble (16) brisable ainsi que plusieurs trous de passage et de vissage (17, 18) pour la fixation dsu capuchon intérieur (3) à l'aide de vis mordant dans les canaux à vis (9) des profilés latéraux intérieurs (1) et la fixation du capuchon extérieur (4)au capuchon intérieur (3).

7. Boîtier de contrôle selon l'une des revendications 1 à 6,
caractérisé en ce que
les deux côtés longitudinaux du capuchon intérieur (3) présentent une rainure (20) qui s'éted en arc (20a) à distance de la pièce d'emboîtement (15), cet arc étant en alignement avec les rainures (10) des profilés latéraux intérieurs (1), un canal d'insertion du joint d'étanchéité continu (7) étant formé, à proximité de la plaque frontale (5) et de la paroi arrière (5), par la rainure (20) dans les deux capuchons intérieurs (3) et par la rainure (10) dans les deux profilés latéraux intérieurs (1).

8. Boîtier de contrôle selon l'une des revendications 1 à 7,
caractérisé en ce que
l'un des côtés lomgitudinaux du capuchon extérieur (4) présente un bord longitudinal droit (4a), tandis que le côté longitudinal opposé possède un bord longitudinal (4b) en retrait en forme d'excavation et deux cols latéraux (4c), arqués en forme de C qui s'engagent dans les profilés latéraux extérieurs (2).

9. Boîtier de contrôle selon l'une des revendications 1 à 8,
caractérisé en ce que
les cols (4c) du bord longitudinal droit (4a) du capuchon extérieur (4) se terminent en un gradin (4d) qui saisit, pour la fixer, la plaque frontale (5) resp. la paroi arrière (5) et le capuchon intérieur (3) et que des trous de passage (19) sont prévus pour les vis de fixation qui mordent dans les trou de passage (18) du capuchon intérieur (3).

10. Boîtier de contrôle selon l'une des revendications 1 à 9,
caractérisé en ce
que le profilé latéral extérieur (2) présente une section transversale en C avec des surfaces de manipulation (21) profilées vers l'exté-rieur et deux arcs en C (2a, 2b) de différentes lon-gueurs, l'un de ces arcs (2a) étant pourvu d'une butée (22) formée à partir de lui et à l'aide de laquelle le profilés latéral extérieur (2) prend appui contre le pont (lc) des profilés latéraux intérieurs (1)

11. Boîtier de contrôle selon l'une des revendications 1 à 10,
caractérisé en ce que
le capuchon extérieur (4) est exécuté en col adéquatement à la section transversale en C des profilés latéraux extérieurs (2) et se termine au niveau des profilés latéraux extérieurs (2) dans la zone de jointure.

12. Boîtier de contrôle selon l'une des revendications 1 à 11,
caractérisé en ce que
le joint d'étanchéité (6) présente la forme d'une plaque en caoutchouc rectangulaire estampée et est équipé d'un nez (6a) correspondant à la plus longue branche (1b) du U du profilé latéral intérieur (1) et d'ajours (12) pour les pièce d'emboîtement (15), de rainures (13) pour le joint d'étanchéité continu (7) et de trous de passage (14) pour les vis destinées à fixer le capuchon intérieur (3) au profilés latéraux intérieurs (1).

13. Boîtier de contrôle selon l'une des revendications 1 à 12,
caractérisé en ce que
la plaque frontale (5) et la paroi arrière (5) sont formées par des plaques rectangulaires pourvues de trous de passage pour les vis destinées à leur fixation sur les capuchons intérieurs (3) et les profilés latéraux intérieurs (1).
